(19) Europäisches Patentamt
European Patent Office
Office européen des brevets

(11) **EP 2 914 066 A1**

(12) **EUROPEAN PATENT APPLICATION**
published in accordance with Art. 153(4) EPC

(43) Date of publication:
**02.09.2015 Bulletin 2015/36**

(51) Int Cl.:
**H05B 33/10** (2006.01)    **H01L 51/50** (2006.01)
**H05B 33/02** (2006.01)    **H05B 33/04** (2006.01)

(21) Application number: **13851226.4**

(86) International application number:
**PCT/JP2013/076831**

(22) Date of filing: **02.10.2013**

(87) International publication number:
**WO 2014/069151 (08.05.2014 Gazette 2014/19)**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**

(30) Priority: **29.10.2012  JP 2012237895**

(71) Applicant: **Nitto Denko Corporation**
**Ibaraki-shi, Osaka 567-8680 (JP)**

(72) Inventors:
• **OSAKI, Yoshinori**
  **Ibaraki-shi**
  **Osaka 567-8680 (JP)**
• **YAMAMOTO, Satoru**
  **Ibaraki-shi**
  **Osaka 567-8680 (JP)**

(74) Representative: **Grünecker Patent- und Rechtsanwälte**
**PartG mbB**
**Leopoldstraße 4**
**80802 München (DE)**

(54) **METHOD FOR MANUFACTURING ORGANIC ELECTROLUMINESCENT PANEL USING ROLL-TO-ROLL PROCESS**

(57)    An organic electroluminescence panel is produced using a roll-to-roll method. The method includes an element forming step of forming an organic electroluminescence element on a flexible substrate, a protective layer forming step of forming a protective layer on the organic electroluminescence element, and a sealing step of bonding a sealing film onto the protective layer, wherein the element forming step, the protective layer forming step and the sealing step are carried out successively in a vacuum chamber without winding the substrate in the form of a roll. By using such the production method, an organic electroluminescence panel having excellent durability can be produced.

Fig.3

EP 2 914 066 A1

**Description**

TECHNICAL FIELD

The present invention relates to a method for producing an organic electroluminescence panel excellent in durability using a roll-to-roll method.

BACKGROUND ART

A method for continuously producing an organic electroluminescence panel using a roll-to-roll method has been heretofore known. Hereinafter, the organic electroluminescence is referred to as "organic EL".

For example, Patent Document 1 discloses forming a first protective film on an organic EL element in-line in a roll-to-roll method, then winding the organic EL element in the form of a roll under an atmospheric pressure environment, and forming a second protective film on the first protective film off-line under an atmospheric pressure environment. The term "in-line" indicates a step including unwinding a flexible substrate from a roll and winding the flexible substrate in the form of a roll again, and the term "off-line" indicates a step after winding the flexible substrate in the form of a roll.

However, very small pinholes and cracks may be generated on the first protective film formed beforehand. When the flexible substrate is wound immediately after formation of the first protective layer, the first protective layer may be damaged. Accordingly, when the substrate is exposed off-line under an atmospheric pressure environment, moisture, oxygen and the like may infiltrate into the organic EL element. An organic EL panel having an organic EL element containing moisture and the like has poor durability, so that its product life is reduced, and therefore improvement is required in this respect.

Further, when the second protective film is formed under an atmospheric pressure environment, minute bubbles may exist between the first protective film and the second protective film. Particularly, when a sealing film provided with an adhesive layer is used as the second protective film, minute bubbles more likely exist between a back surface of the adhesive layer and a surface of the first protective film and inside the adhesive layer. Existence of such bubbles reduces durability and visibility of an organic EL panel, and improvement is required in this respect.

[Patent Document 1] JP 4696832 B (JP 2007-109592 A)

SUMMARY OF INVENTION

An object of the present invention is to provide a method for producing an organic EL panel excellent in durability.

A method for producing an organic EL panel of the present invention is performed using a roll-to-roll method. The method includes an element forming step of forming an organic EL element on a flexible substrate, a protective layer forming step of forming a protective layer on the organic EL element, and a sealing step of bonding a sealing film onto the protective layer, wherein the element forming step, the protective layer forming step, and the sealing step are carried out successively in a vacuum chamber without winding the substrate in the form of a roll.

In a preferable method of the present invention, the method further includes a heating step of heating the flexible substrate in the vacuum chamber before the element forming step.

In the production method of the present invention, the element forming step, the protective layer forming step and the sealing step are carried out successively in the vacuum chamber, so that damage of the protective layer can be prevented, and infiltration of moisture and oxygen into the protective layer through very small pinholes and cracks can be suppressed. Further, ingress of bubbles between the sealing film and the protective layer can be prevented. An organic EL panel obtained by the production method of the present invention is excellent in durability because moisture, oxygen and the like are hard to infiltrate into the organic EL element.

BRIEF DESCRIPTION OF THE DRAWINGS

Fig. 1 is a plan view of an organic EL panel according to one embodiment of the present invention.
Fig. 2 is an enlarged sectional view taken along the line II-II in Fig. 1.
Fig. 3 is a block diagram of a method for producing an organic EL panel according to the present invention.
Fig. 4 is a schematic view of steps in the production method.
Fig. 5 is a plan view of a laminate (sealing film with a separator).
Fig. 6 is an enlarged sectional view taken along the line VI-VI in Fig. 5.
Fig. 7 is a schematic side view of an apparatus for bonding a sealing film for carrying out a sealing step.

Fig. 8 is an enlarged sectional view of the organic EL panel produced in Example.

Hereinafter, the present invention will be described with reference to the drawings. It should be noted that dimensions such as a layer thickness and a length in the drawings are different from actual dimensions.

In this specification, the terms "first" and "second" may be added as prefixes. These prefixes, however, are only added in order to distinguish the terms and do not have specific meaning such as order and relative merits. The "belt shape" means a substantially rectangular shape in which a length in one direction is sufficiently larger than a length in the other direction. The "belt shape" is a substantially rectangular shape in which a length in one direction is 10 times or more, preferably 30 times or more, more preferably 100 times or more of a length in the other direction. The "long direction" is one direction of the belt shape (direction parallel to the longer side of the belt shape), and the "short direction" is the other direction of the belt shape (direction parallel to the shorter side of the belt shape). The wording "PPP to QQQ" indicates "PPP or more and QQQ or less".

[Configuration of Organic EL Panel]

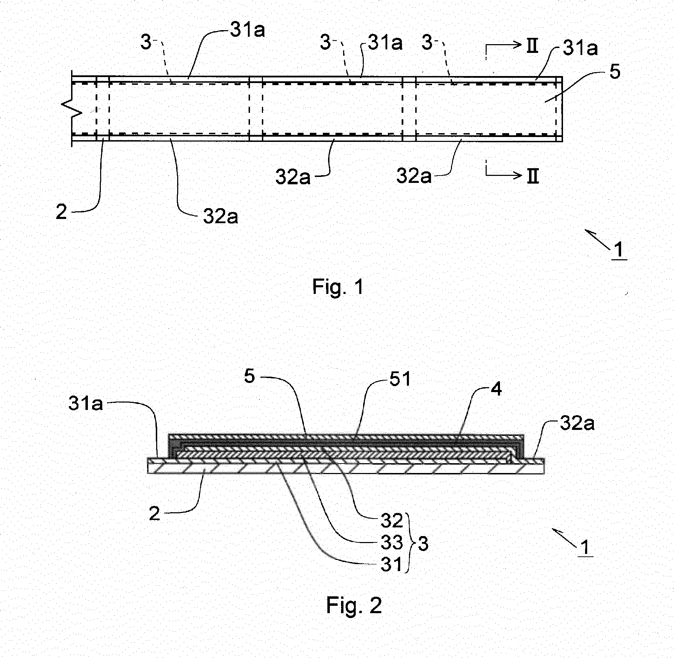

As illustrated in Fig. 1 and Fig. 2, an organic EL panel 1 of the present invention includes a belt-shaped flexible substrate 2, a plurality of organic EL elements 3 provided side by side on the belt-shaped flexible substrate 2 along the long direction thereof, a protective layer 4 provided on the organic EL elements 3, and a sealing film 5 provided on the protective layer 4. Hereinafter, the flexible substrate may be referred to simply as a "substrate".

The organic EL element 3 includes a first electrode 31 having a terminal 31a, a second electrode 32 having a terminal 32a, and an organic layer 33 provided between the electrodes 31 and 32.

In each of the organic EL elements 3, the terminal 31a of the first electrode 31 is arranged on a first side in the short direction and the terminal 32a of the second electrode 32 is arranged on a second side in the short direction with respect to the organic layer 33. The first side and the second side in the short direction are opposite to each other, and when referring to Fig. 1, the first side in the short direction is the upper side and the second side in the short direction is the lower side.

The sealing film 5 is provided on the organic EL elements 3 so as to cover a surface of each organic EL element 3, exclusive of the terminals 31a and 32a.

The organic EL elements 3 are disposed in a line in the short direction of the substrate 2, and the organic EL elements 3 are arranged at necessary intervals in the long direction of the substrate 2.

The organic EL panel 1 of the present invention is also an assembly of organic EL panels in which a plurality of organic EL panels are provided in series in the longer direction by means of the belt-shaped substrate 2.

By cutting the assembly of organic EL panels at a boundary between adjacent organic EL elements 3, individual organic EL panels (organic EL panel pieces) can be taken out.

The plane shape of the substrate 2 is a belt shape.

A length of the belt shape of the substrate 2 (length in a long direction) is not particularly limited, but it is 10m to 1000m, for example. Furthermore, a width of the substrate 2 (length in a short direction) is not particularly limited, but for example, it is 10mm to 300mm, preferably 10mm to 100mm. A thickness of the substrate 2 is also not particularly limited, and it is appropriately designed in consideration of the material thereof. When a metal substrate or a synthetic resin substrate is used as the substrate 2, the thickness is $10\mu m$ to $50\mu m$, for example.

As illustrated in Fig. 2, a laminate structure of the organic EL panel 1 includes the substrate 2, the first electrode 31 provided on the substrate 2, the organic layer 33 provided on the first electrode 31, the second electrode 32 provided on the organic layer 33, the protective layer 4 provided on the second electrode layer 32, and the sealing film 5 provided on the protective layer 4.

When the substrate 2 has electric conductivity, an insulating layer (not illustrated) is provided between the substrate 2 and the first electrode 31 in order to prevent an electrical short-circuit.

A length of the organic EL element 3 corresponding to the long direction of the substrate 2 is larger than a length of the organic EL element 3 corresponding to the short direction of the substrate 2. In the illustrated example, the plane shape of the organic EL element 3 is a substantially rectangular shape having a longer side in the long direction and a shorter side in the short direction of the substrate 2.

However, the organic EL element 3 does not necessarily have a substantially rectangular shape, but may have, for example, a substantially elliptical shape which is long in the long direction of the substrate 2 (not illustrated). In the organic EL panel 1 of the present invention, the organic EL element 3 does not necessarily have a shape in which a length corresponding to the long direction of the substrate 2 is larger than a length corresponding to the short direction of the substrate 2. For example, the present invention also includes the organic EL panel 1 in which the shape of the organic EL element 3 in plane view is a substantially square or circular shape (not illustrated).

The organic layer 33 of the organic EL element 3 includes a light emitting layer, and has various kinds of functional layers such as a positive hole transport layer and an electron transport layer, as necessary. The layer configuration of the organic layer 33 is described later.

For forming the terminal 31a of the first electrode 31, the organic layer 33 is provided on the first electrode 31, exclusive of the end portion (terminal 31a) of the first electrode 31 on the first side in the short direction.

The second electrode 32 is provided on the organic layer 33 so as to cover a surface of the organic layer 33. For forming the terminal 32a of the second electrode 32, the end portion (terminal 32a) of the second electrode 32 is drawn from the end portion of the organic layer 33 to the second side in the short direction.

The terminals 31a and 32a of the first electrode 31 and the second electrode 32 are portions that are connected to the outside. The terminal 31a of the first electrode 31 is an exposed surface of the first electrode 31, and the terminal 32a of the second electrode 32 is an exposed surface of the second electrode 32.

Organic EL elements 3 adjacent in the longer direction are not in contact with each other, but are slightly spaced from each other.

The sealing film 5 is a layer for preventing infiltration of oxygen, water vapor, and the like into the organic EL element 3.

The sealing film 5 is a belt-shaped film. The sealing film 5 is provided on the surface of each protective layer 4 over a plurality of organic EL elements 3 so as not to cover the terminals 31a and 32a of the first electrode 31 and the second electrode 32.

Specifically, the sealing film 5 is in close contact with the surface of the protective layer 4, exclusive of the terminals 31a and 32a. The sealing film 5 may be in close contact with not only the surface of the protective layer 4 but also both side portions of the organic EL element 3. The fringe portion of the sealing film 5 is adhered to the surface of the substrate 2, the surfaces of the first electrodes 31, and the surfaces of the second electrodes 32.

For bonding the sealing film 5 to the surface of the protective layer 4, etc. an adhesive layer 51 is provided on the back surface of the sealing film 5 as illustrated in Fig. 2. The sealing film 5 is adhered to the organic EL elements 3 including the protective layer 4, with the adhesive layer 51 interposed therebetween.

An organic EL panel 1 of the present invention can be used as a light emitting panel such as an image display, an illuminating device, and the like as the organic layer 33 is formed of a light emitting material.

Regarding the organic EL panel 1 having the organic layer 33 including a light emitting layer, a forming material thereof is explained below.

(Belt-Shaped Substrate)

A substrate is a belt-shaped flexible substrate. The flexible substrate is a flexible sheet-shaped material that can be wound in the form of a roll.

The substrate may be either transparent or opaque. When a bottom emission type organic EL panel is formed, a transparent substrate is used.

In this specification, the index of transparency may be, for example, a total light transmittance of 70% or more, preferably 80% or more. It is to be noted that the total light transmittance is a value measured by a measurement method conforming to JIS K7105 (Method of Testing Optical Characteristics of Plastics).

While a material of the substrate is not particularly limited, examples thereof include glass substrates, metal substrates, synthetic resin substrates, and ceramic substrates. Examples of the synthetic resin substrate include synthetic resin films such as those of polyester-based resins such as polyethylene terephthalate (PET), polyethylene naphthalate (PEN), and polybutylene terephthalate (PBT); olefin-based resins having an α-olefin as a monomer component, such as polyethylene (PE), polypropylene (PP), polymethylpentene (PMP), ethylene-propylene copolymers, and ethylene-vinyl acetate copolymers (EVA); polyvinyl chloride (PVC); vinyl acetate-based resins; polycarbonate (PC); polyphenylene sulfide (PPS); amide-based resins such as polyamide (nylon) and wholly aromatic polyamide (aramid); polyimide-based resins; and polyether ether ketone (PEEK). Examples of the metal substrate include thin plates formed of stainless steel, copper, titanium, aluminum, and alloys.

For preventing a rise in temperature of the organic EL panel at the time of driving, the substrate is preferably excellent in heat dissipation. For preventing infiltration of oxygen and water vapor into the organic EL panel, the substrate preferably has gas and water vapor barrier properties.

When a metal substrate is used, an insulating layer is provided on a surface of the metal substrate in order to insulate the substrate against an electrode formed on the surface thereof.

(First Electrode of Organic EL Element)

A first electrode is an anode, for example.

The formation material of the first electrode (anode) is not particularly limited, but examples include indium tin oxide (ITO); indium tin oxide including silicon oxide (ITSO); aluminum; gold; platinum; nickel; tungsten; copper; and an alloy. A thickness of the first electrode is not particularly limited, but it is usually 0.01 $\mu$m to 1.0 $\mu$m.

(Organic Layer of Organic EL Element)

An organic layer is a laminate composed of at least two layers. Examples of a structure of the organic layer include (A) a structure composed of three layers including a positive hole transport layer, a light emitting layer, and an electron transport layer; (B) a structure composed of two layers including a positive hole transport layer and a light emitting layer; and (C) a structure composed of two layers including a light emitting layer and an electron transport layer.

In the organic layer of the above-mentioned (B), the light emitting layer also works as an electron transport layer. In the organic layer of the above-mentioned (C), the light emitting layer works as a positive hole transport layer.

The organic layer used in the present invention can have any of the structures (A) to (C) mentioned above.

The organic layer having the structure (A) is explained below.

The positive hole transport layer is provided on the surface of the first electrode. An arbitrary function layer other than the first electrode and the positive hole transport layer may be interposed between the first electrode and the positive hole transport layer under the conditions in which the light emitting efficiency of the organic EL element is not lowered.

For example, the positive hole injection layer is provided on the surface of the first electrode, and the positive hole transport layer may be provided on the surface of the positive hole injection layer. The positive hole injection layer is a layer having a function of aiding injection of a positive hole from the anode layer to the positive hole transport layer.

A formation material of the positive hole transport layer is not particularly limited as long as the formation material has a positive hole transport function. Examples of the formation material for the positive hole transport layer include an aromatic amine compound such as 4,4',4''-tris(carbazole-9-yl)-triphenyl amine (abbreviation: TcTa); a carbazole derivative such as 1,3-bis(N-carbazolyl) benzene; a spiro compound such as N,N'-bis(naphthalene-1-yl)-N,N'-bis(phenyl)-9,9'-spiro-bisfluorene (abbreviation: Spiro-NPB); a polymer compound; and the like. The formation material of the positive hole transport layer may be used singly or in combination of two or more formation materials. Furthermore, the positive hole transport layer may be a multi-layer structure having two or more layers.

A thickness of the positive hole transport layer is not particularly limited, but the thickness of 1 nm to 500 nm is preferable from the viewpoint of reducing drive voltage.

A light emitting layer is provided on the surface of the positive hole transport layer.

A formation material of the light emitting layer is not particularly limited as long as it has light emitting property. Examples of the formation material of the light emitting layer include a low molecular light emission material such as a low molecular fluorescence emission material, and a low molecular phosphorescence emission material.

Examples of the low molecular light emission material include an aromatic dimethylidene compound such as 4,4'-bis(2,2'-diphenyl vinyl)-biphenyl (abbreviation: DPVBi); an oxadiazole compound such as 5-methyl-2-[2-[4-(5-methyl-2-benzoxazolyl)phenyl]vinyl]benzoxazole; a triazole derivative such as 3-(4-biphenyl-yl)-4-phenyl-5-t-butyl phenyl-1,2,4-triazole; a styryl benzene compound such as 1,4-bis(2-methyl styryl)benzene; a benzoquinone derivative; a naphthoquinone derivative; an anthraquinone derivative; a fluorenone derivative; an organic metal complex such as an azomethine-zinc complex, tris(8-quinolinolato) aluminum (abbreviation: $Alq_3$), and the like.

Furthermore, as the formation material for the light emitting layer, a host material doped with light emitting dopant material may be used.

For the host material, for example, the above-mentioned low molecular light emission material can be used, and, other than this, a carbazole derivative such as 1,3,5-tris(carbazo-9-yl)benzene (abbreviation: TCP), 1,3-bis(N-carbazolyl)benzene (abbreviation: mCP), 2,6-bis(N-carbazolyl)pyridine, 9,9-di(4-dicarbazole-benzyl)fluorene (abbreviation: CPF), 4,4'-bis(carbazole-9-yl)-9,9-dimethyl-fluorene (abbreviation: DMFL-CBP), and the like can be used.

Examples of the dopant material include a styryl derivative; a perylene derivative; a phosphorescence emission metal complex including an organic iridium complex such as tris(2-phenyl pyridyl)iridium (III) ($Ir(ppy)_3$), tris(1-phenyl isoquinoline)iridium (III) ($Ir(piq)_3$), and bis(1-phenyl isoquinoline) (acetylacetonato) iridium (III) (abbreviation: $Ir(piq)_2(acac)$), and the like.

Furthermore, the formation material of the light emitting layer may include such as the formation material for the positive hole transport layer mentioned above, the formation material of the electron transport layer mentioned below, and various additives.

A thickness of the light emitting layer is not particularly limited, but the thickness of 2 nm to 500 nm is preferable, for example.

The electron transport layer is provided on the surface of the light emitting layer. An arbitrary function layer other than the second electrode and the electron transport layer may be interposed between the second electrode and the electron transport layer under the conditions in which the light emitting efficiency of the organic EL element is not lowered.

For example, the electron injection layer is provided on the surface of the electron transport layer, and the second electrode is provided on the surface of the electron injection layer. The electron injection layer is a layer having a function of aiding injection of an electron from the second electrode to the electron transport layer.

A formation material of the electron transport layer is not particularly limited as long as it is a material having an electron transport function. Examples of the formation material of the electron transport layer include a metal complex such as tris(8-quinolinolato) aluminum (abbreviation: Alq$_3$), bis(2-methyl-8-quinolinolato)(4-phenyl phenolate) aluminum (abbreviation: BAlq); a heteroaromatic compound such as 2,7-bis[2-(2,2'-bipyridine-6-yl)-1,3,4-oxadiazo-5-yl]-9,9-dimethyl fluorene (abbreviation: Bpy-FOXD), 2-(4-biphenylyl)-5-(4-tert-butyl phenyl)-1,3,4-oxadiazole (abbreviation: PBD), 1,3-bis[5-(p-tert-butyl phenyl)-1,3,4-oxadiazole-2-yl]benzene (abbreviation: OXD-7), and 2,2',2"-(1,3,5-phenylene)-tris(1-phenyl-1H-benzimidazole) (abbreviation: TPBi); and a polymer compound such as poly(2,5-pyridine-diyl) (abbreviation: PPy). The formation material of the electron transport layer may be used singly or in combination of two or more types. Furthermore, the electron transport layer may have a multi-layered structure composed of two or more layers.

A thickness of the electron transport layer is not particularly limited, but the thickness of 1 nm to 500 nm is preferable from the viewpoint of reducing drive voltage.

(Second Electrode of Organic EL Element)

A second electrode is a cathode, for example.

A formation material of the cathode is not particularly limited, but a transparent second electrode is used when a top emission organic EL element is formed. Examples of the formation material of the second electrode which is transparent and has electric conductivity include indium tin oxide (ITO); indium tin oxide including silicon oxide (ITSO); zinc oxide in which electric conductive metal such as aluminum is added (ZnO : Al); and a magnesium-silver alloy, and the like. A thickness of the second electrode is not particularly limited, but it is usually 0.01 $\mu$m to 1.0 $\mu$m.

(Protective Layer)

A protective layer is provided for protecting the organic EL element and preventing infiltration of moisture and oxygen.

While a forming material for the protective layer is not particularly limited, but examples include a metal oxide film, an oxynitride film, a nitride film, and a carbide nitride oxide film. Examples of the metal oxide film include MgO, SiO, Si$_x$O$_y$, Al$_2$O$_3$, GeO, and Ti$_2$O.

The protective layer is preferably a silicon carbide nitride oxide film (SiOCN), a silicon oxynitride film (SiON), and a silicon nitride film (SiN).

A thickness of the protective layer is not particularly limited, but it is 50 nm to 50 $\mu$m, for example.

(Sealing Film)

As a material for forming the sealing film, a synthetic resin such as an ethylene tetrafluoroethyl copolymer (ETFE), high density polyethylene (HDPE), oriented polypropylene (OPP), polystyrene (PS), polymethyl methacrylate (PMMA), oriented nylon (ONy), polyethylene terephthalate (PET), polycarbonate (PC), polyimide, polyether styrene (PES), or polyethylene naphthalate can be suitably used. As the sealing film, a metallic thin plate formed of stainless steel, copper, titanium, aluminum, or an alloy can also be used. For preventing infiltration of oxygen and water vapor into the organic EL panel, the sealing film preferably has gas and water vapor barrier properties.

A thickness of the sealing film is not particularly limited, but for example, it is 5 $\mu$m to 1 mm and preferably 10 $\mu$m to 500 $\mu$m.

The adhesive layer for adhering the sealing film to the organic EL element is formed from a known adhesive. It is preferred to use, for example, a thermosetting or photo-setting adhesive as the above-mentioned adhesive. The adhesive is adjusted to an appropriate viscosity, and provided on the back surface of the sealing film with a uniform thickness.

[Method for Producing Organic EL Panel]

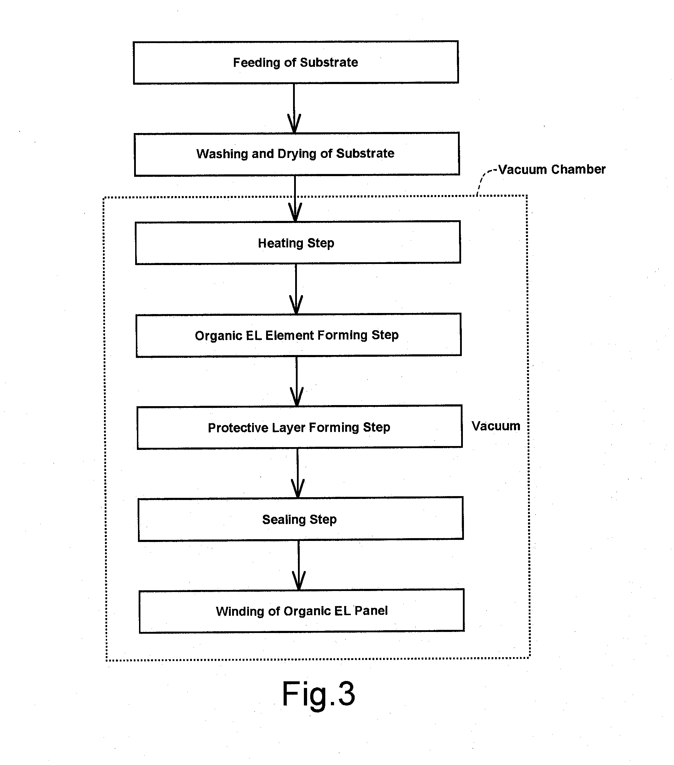

A method for producing an organic EL panel according to the present invention includes: an element forming step of forming an organic EL element on a belt-shaped flexible substrate; a protective layer forming step of forming a protective layer on the organic EL element; and a sealing step of bonding a sealing film onto the protective layer, wherein the element forming step, the protective layer forming step, and the sealing step are carried out successively in a vacuum chamber without winding the substrate in the form of a roll (see Fig. 3). Preferably, the method further includes a heating step of heating the flexible substrate in the vacuum chamber before the element forming step. The method for producing an organic EL panel according to the present invention includes a drawing step of unwinding a belt-shaped flexible substrate wound in the form of a roll in the first place.

The organic EL panel of the present invention is produced using a roll-to-roll method.

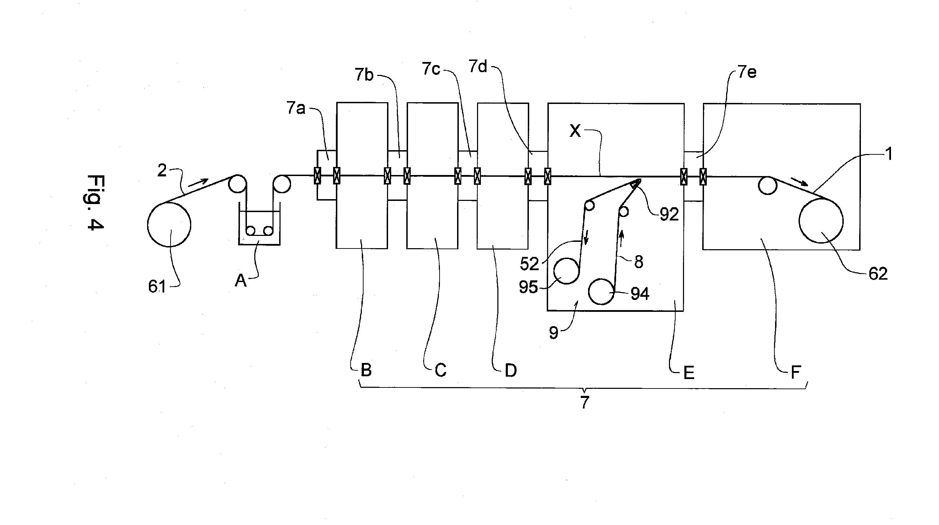

Fig. 4 is a schematic view of the production steps.

In Fig. 4, the flexible substrate 2 unwound from a roll 61 is washed with pure water in a washing section A and dried as necessary. Thereafter, the substrate 2 is introduced into a vacuum chamber 7.

The vacuum chamber 7 includes one closed space. The closed space is provided with at least an element forming step section C, a protective layer forming step section D, and a sealing step section E. In the closed space, a heating step section B is provided before the element forming step section C, and a winding step section F is provided after the sealing step section E as necessary. The vacuum chamber 7 is configured such that vacuum rooms having these step sections are provided in series with involvement of pressure adjustment sections.

Specifically, the vacuum chamber 7 includes a room having a first pressure adjustment section 7a and the heating step section B, a room having a second pressure adjustment section 7b and the element forming step section C, a room having a third pressure adjustment section 7c and the protective layer forming step section D, a room having a fourth pressure adjustment section 7d and the sealing step section E, and a room having a fifth pressure adjustment section 7e and the winding step section F, in this order.

An entrance and an exit (on the upstream side and the downstream side in a feeding direction of the substrate 2) of each of the pressure adjustment sections 7a, 7b, 7c, 7d, and 7e are provided with gaps through which the flexible substrate 2 can pass without causing contact between the surface of the substrate 2 and the pressure adjustment section (not illustrated). The pressure adjustment sections 7a, 7b, 7c, 7d, and 7e can adjust a pressure by differential evacuation, so that the inside the room of each of the element forming step section C, the protective layer forming step section D, and the sealing step section E to each suitable vacuum degree. The vacuum degree of the inside of each of rooms having these step sections is not particularly limited. Preferably, the vacuum degree of the element forming step section C is kept at $1 \times 10^{-4}$ Pa or less, the vacuum degree of the protective layer forming step section D is kept at $1 \times 10^{-1}$ Pa or less, and the vacuum degree of the sealing step section E is kept at several hundreds of Pa or less. The vacuum degree of the heating step section B is several hundreds of Pa or less, and the vacuum degree of the winding step section F is several hundreds of Pa or less.

The winding step section F may be provided on the outside of the vacuum chamber 7.

The sealing step section E is provided with a bonding apparatus for bonding a sealing film to a protective layer of an organic EL element.

The bonding apparatus 9 includes a conveyance roller 94 for conveying a laminate 8 including a sealing film, a collection roller 95 for collecting a separator 52, and a peel plate 92 for peeling off the sealing film. The conveyance roller 94 and the collection roller 95 are provided in the vacuum chamber 7. That is, the whole of the bonding apparatus 9 is provided in the room of the sealing step section E. Of course, the conveyance roller 94 and the collection roller 95 are not necessarily provided in the vacuum chamber 7, but may be provided on the outside of the vacuum chamber 7 (not illustrated).

The sealing step using the bonding apparatus is described in detail later.

The belt-shaped organic EL panel 1 of the present invention is obtained by bonding the sealing film. The belt-shaped organic EL panel 1 is wound around a roll 62.

(Drawing Step)

The belt-shaped flexible substrate wound in the form of a roll is unwound, and introduced into the vacuum chamber.

The unwound flexible substrate is introduced into a previously known washing tank, washed and then dried as necessary before being introduced into the vacuum chamber.

A substrate with a first electrode patterned beforehand may be used. When a substrate with a first electrode patterned beforehand is used, the substrate is unwound from the roll, washed and dried, and then introduced into the vacuum chamber.

The element forming step, the protective layer forming step, and the sealing step are carried out successively in a vacuum chamber without winding the unwound substrate in the form of a roll at least in the element forming step, the protective layer forming step, and the sealing step.

(Heating Step)

The heating step is a step of heating the flexible substrate for removing moisture contained in the flexible substrate. Preferably, the heating step is carried out in the vacuum chamber.

The heating method is not particularly limited, and examples thereof include heating with an appropriate heater such as an infrared heater.

While the heating temperature is not particularly limited, the heating temperature is adjusted in consideration of a heat resistance temperature of the flexible substrate, and is preferably 100°C or higher, for example. By performing the above-mentioned heating before formation of the element, degradation of the organic EL element by moisture generated from the flexible substrate can be suppressed. By carrying out the heating step in the vacuum chamber, the heating time can be reduced.

After the heating step and before the element forming step, a step of cooling the substrate may be provided as necessary.

(Element Forming Step)

Formation of the organic EL element may be performed in the same manner as heretofore as long as it is performed in a vacuum chamber.

To explain it briefly, a first electrode is formed on the belt-shaped substrate introduced in the vacuum chamber.

As the formation method of the first electrode, an optimum method can be employed depending on the formation material, and examples of the method include a sputtering method, a vapor deposition method, an ink-jet method, and the like. For example, when the anode is formed of metal, the vapor deposition method is used.

When a substrate with a first electrode patterned beforehand is used, formation of the first electrode is omitted.

A positive hole transport layer, a light emitting layer, and an electron transport layer are formed in this order on the first electrode, exclusive of a terminal thereof.

As the formation method of the positive hole transport layer and the electron transport layer, an optimum method can be employed depending on the formation material, and examples of the method include a sputtering method, a vapor deposition method, an ink-jet method, and the like.

As the formation method of the light emitting layer, an optimum method can be employed depending on the formation material, but usually it is formed by a vapor deposition method.

Subsequently, the second electrode is formed on the organic layer. The second electrode is formed so as not to cover the terminal of the first electrode. As the formation method of the second electrode, an optimum method can be employed depending on the formation material, and examples of the method include a sputtering method, a vapor deposition method, an ink-jet method, and the like.

In this way, a plurality of organic EL elements are formed at necessary intervals on the substrate.

(Protective Layer Forming Step)

Formation of the protective layer is performed in the vacuum chamber subsequently to the element forming step.

Formation of the protective layer may be performed in the same manner as heretofore. While as a formation method of the protective layer, an optimum method can be employed depending on the forming material for the protective layer, examples thereof include a sputtering method, a plasma-enhanced CVD method, an ion plating method, and a plasma-assisted vapor deposition method.

(Sealing Step)

Bonding of the sealing film is performed in the vacuum chamber subsequently to the protective layer forming step.

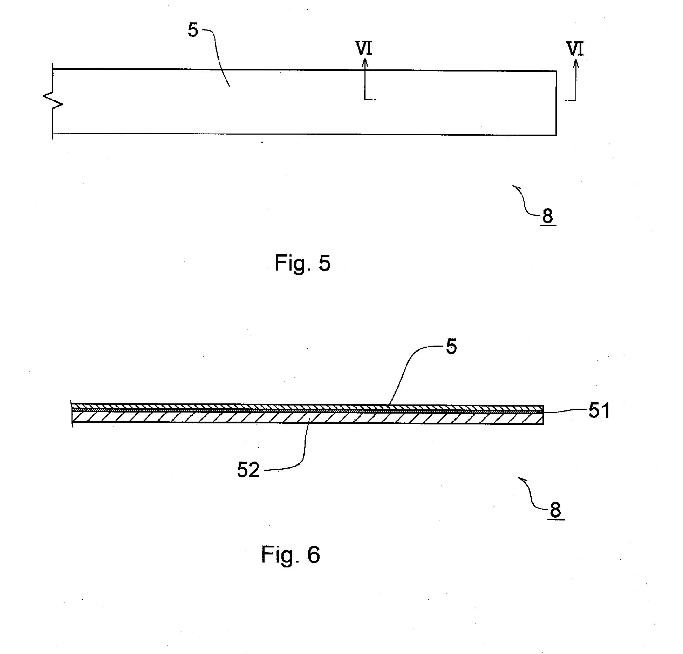

Figs. 5 and 6 show one example of the laminate 8 (sealing film with a separator).

The laminate 8 includes the sealing film 5, the adhesive layer 51 laminated on the back surface of the sealing film 5, and the separator 52 peelably bonded to the back surface of the adhesive layer 51.

The plane shape of the separator 52 is a belt shape. The belt-shaped sealing film 5 is temporarily bonded on the surface of the belt-shaped separator 52 with the adhesive layer 51 interposed therebetween.

The laminate 8 is normally prepared outside the vacuum chamber. Of course, the laminate 8 can also be prepared in the vacuum chamber if equipment for forming the laminate 8 is installed in the vacuum chamber.

As the forming material for the sealing film 5, those shown above as an example are used.

As the separator 52, a sheet-shaped article having a surface subjected to a mold releasability imparting treatment so that the adhesive layer is easily peeled off is used. The forming material for the separator 52 is not particularly limited, and examples thereof include a synthetic resin film, a synthetic paper, and a paper subjected to a mold releasability imparting treatment.

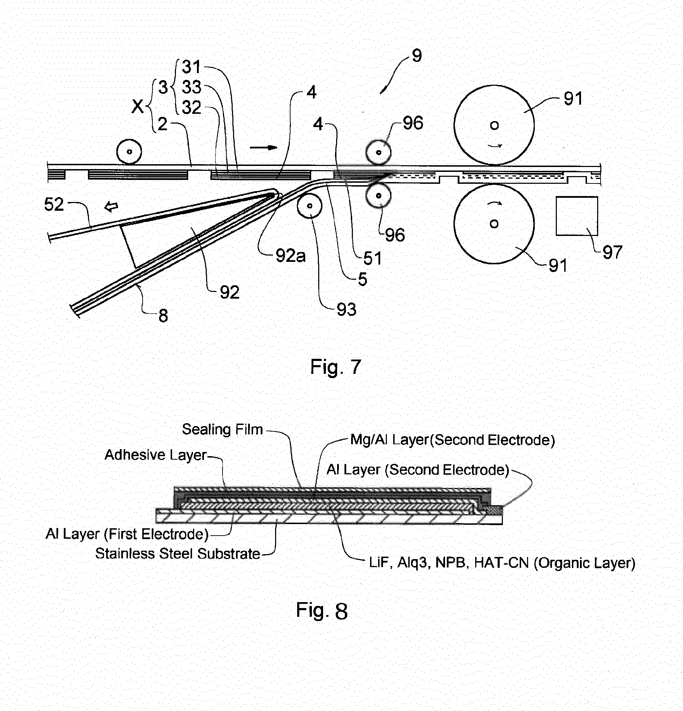

Fig. 7 is a schematic view of an apparatus for bonding a sealing film, which is used in the sealing step. Fig. 7 is also an enlarged view of the inside of the sealing step section E in the vacuum chamber 7 in Fig. 4.

Referring to Figs. 4 and 7, the bonding apparatus 9 includes a conveyance roller 91 for feeding an organic EL element-formed substrate X in the longer direction, the peel plate 92 for separating the separator 52 and the sealing film 5 from each other, a guide roller 93 disposed at a leading end portion 92a of the peel plate 92, the conveyance roller 94 (illustrated in Fig. 4, but not illustrated in Fig. 7) for feeding the laminate 8 (sealing film with a separator) to the peel plate 92, the collection roller 95 (illustrated in Fig. 4, but not illustrated in Fig. 7) for collecting the separator 52, a pressing roller 96 for pressing the surface of the sealing film 5 peeled off from the separator 52, and a curing unit 97 for curing the adhesive layer 51 provided on the back surface of the sealing film 5.

The peel plate 92 is a plate-shaped body formed in the shape of an acute angled triangle in side view. The peel plate 92 is disposed such that the leading end portion 92a (acute-angled portion) thereof is positioned in the vicinity of a surface of the organic EL element-formed substrate X. The distance between the leading end portion 92a of the peel plate 92 and the surface of the organic EL element-formed substrate X is not particularly limited. Of course, when the above-mentioned distance is excessively small, the leading end portion 92a of the peel plate 92 may come into contact with the surface of the organic EL element 3 to damage the surface of the organic EL element 3. On the other hand, when the above-mentioned distance is excessively long, the sealing film 5 peeled off by the peel plate 92 may not be transferred to the surface of the organic EL element 3. In view of these considerations, the distance between the leading end portion 92a of the peel plate 92 and the surface of the organic EL element-formed substrate X is preferably 2 mm or more, more preferably 3 mm or more. The upper limit of the above-mentioned distance is, for example, 20 mm or less, preferably 10 mm or less although depending on a size of the sealing film 5.

The laminate 8 is fed to the peel plate 92 in synchronization with feeding of the organic EL element-formed substrate X.

At the leading end portion 92a of the peel plate 92, only the separator 52 is turned around and collected. In the figure, the void arrow shows a direction in which the separator 52 is collected.

As the separator 52 is turned around at the leading end portion 92a of the peel plate 92, interlayer peeling occurs between the adhesive layer 51 and the separator 52, so that the sealing film 5 is separated from the separator 52 together with the adhesive layer 51.

The adhesive layer 51 comes into contact with the surface of the organic EL element to bond the sealing film 5 to the organic EL element-formed substrate X. The sealing film 5 is bonded while being appropriately aligned so as not to cover the terminal.

The sealing film 5 is brought into close contact with the protective layer 4 by pressing the sealing film 5 with the pressing roller 96 from above the sealing film 5 bonded onto the protective layer 4.

Thereafter, the adhesive layer 51 is cured by the curing unit 97 provided on the downstream side of the pressing roller 96, whereby the sealing film 5 is fixed, so that sealing of the organic EL elements 3 is completed. As the curing unit, an optimum apparatus is used according to a type of adhesive. A heater is used for the thermosetting adhesive, and a photoirradiation apparatus such as an ultraviolet lamp is used for the photo-setting adhesive.

(Winding Step)

In this way, the belt-shaped organic EL panel 1 with a plurality of organic EL elements 3 sealed by the belt-shaped sealing film 5 as illustrated in Figs. 1 and 2 can be obtained.

The obtained belt-shaped organic EL panel 1 is wound in the form of a roll in the winding step section F as illustrated in Fig. 4.

In the production method of the present invention, an element forming step, a protective layer forming step, and a sealing step are carried out successively in a vacuum chamber, so that damage of a protective layer can be prevented, and infiltration of moisture and oxygen into the protective layer through very small pinholes and cracks can be suppressed. Further, ingress of bubbles between a sealing film and a protective layer can be prevented. According to the present invention, an organic EL panel resistant to infiltration of moisture and oxygen into organic EL elements can be produced, and therefore an organic EL panel having excellent durability and a long product life can be provided.

Further, a sealing film provided with an adhesive layer is used in the sealing step, and therefore the sealing film can be stably bonded to the organic EL element (protective layer).

The organic EL panel of the present invention and the method for production thereof are not limited to the embodiments described above, and a design change may be appropriately made within a scope intended by the present invention.

For example, a laminate including a separator is introduced into a vacuum chamber in the production method of the embodiment described above, but a laminate having no separator (laminate with an adhesive layer provided on the back surface of a sealing film) may be used.

In this case, the laminate having no separator may be produced outside the vacuum chamber, or produced in the vacuum chamber.

EXAMPLES

Hereinafter, the present invention is described in detail with reference to following Examples. However, the present invention is not limited to the following Examples.

[Example]

(Preparation of Laminate Including Flexible Substrate and Sealing Film)

One surface of a stainless steel foil (SUS 304 foil) having a thickness of 30 $\mu$m, a width of 30 mm, and a length of 100 m was coated with an acrylic resin (manufactured by JSR Corporation; trade name "JEM-477") to form an insulating layer having a thickness of 3 $\mu$m. A flexible substrate having a belt-shaped stainless steel foil and an insulating layer (acrylic resin layer) laminated on the foil was thus prepared. The flexible substrate was wound in the form of a roll.

On the other hand, a belt-shaped film (width: 20 mm and length: 100 m) including a polyethylene naphthalate film having a thickness of 50 $\mu$m and a SiO$_2$ layer (barrier layer) deposited on one surface of the film by a sputtering method and having a thickness of 0.3 $\mu$m was prepared as a sealing film. An epoxy-based thermosetting adhesive having a thickness of 40 $\mu$m was provided as an adhesive layer on the other surface of the sealing film, and the adhesive layer was temporarily bonded onto a belt-shaped separator to prepare a belt-shaped laminate including the sealing film. The laminate was wound in the form of a roll.

[Production of Organic EL Panel]

The roll-shaped flexible substrate was unwound, and introduced into a vacuum chamber formed by connecting a plurality of rooms in series with involvement of pressure adjustment sections (see Fig. 4), thereby preparing a belt-shaped organic EL panel. Specific steps are as follows.

(Drawing Step and Heating Step)

The flexible substrate wound in the form of a roll was continuously unwound, and the front and back surfaces of the substrate were washed with pure water, and then dried. The substrate was introduced into a room (heating step section B in Fig. 4) set at a vacuum degree of $1 \times 10^{-1}$ Pa or less, and heating-treated at 150°C for 30 minutes.

(Element Forming Step)

Subsequently, the flexible substrate was fed into a room (element forming step section C in Fig. 4) set at a vacuum degree of $1 \times 10^{-4}$ Pa or less, an Al layer having a thickness of 100 nm was formed on the insulating layer of the substrate by a vapor deposition method as a first electrode having an terminal, a HAT-CN layer having a thickness of 10 nm was formed as a positive hole injection layer on the first electrode, exclusive of the terminal, by a vapor deposition method, a NPB layer having a thickness of 50 nm was formed as a positive hole transport layer on the positive hole injection layer by a vapor deposition method, an Alq$_3$ layer having a thickness of 45 nm was formed as a light emitting layer and electron transport layer on the positive hole transport layer by a vapor deposition method, a LiF layer having a thickness of 0.5 nm was formed as an electron injection layer on the layer as a light emitting layer and electron transport layer by a vapor deposition method, a Mg/Ag layer having a thickness of 2/18 nm was formed as a second electrode on the electron injection layer by a co-vapor deposition method, and an Al layer having a thickness of 100 nm was formed on the end portion of the second electrode by a vapor deposition method in order to provide a terminal of the second electrode.

An organic EL element-formed substrate was thus prepared in which a plurality of organic EL elements having the layer configuration described below were formed at predetermined intervals in the long direction of the flexible substrate.

[Layer Configuration of Organic EL Element]

Second electrode having a terminal: Al layer having a thickness of 100 nm
Second electrode: Mg/Ag layer having a thickness of 2/18 nm
Electron injection layer: LiF layer having a thickness of 0.5 nm
Layer as light emitting layer and electron transport layer: Alq$_3$ layer having a thickness of 45 nm
Positive hole transport layer: NPB layer having a thickness of 50 nm
Positive hole injection layer: HAT-CN layer having a thickness of 10 nm
First electrode having a terminal: Al layer having a thickness of 100 nm
Here the above-mentioned HAT-CN is 1,4,5,8,9,12-hexaazatriphenylene hexacarbonitrile.

(Protective Layer Forming Step)

Subsequently, the organic EL element-formed substrate was fed into a room (protective layer forming step section D in Fig. 4) set at a vacuum degree of $1 \times 10^{-1}$ Pa or less, and a SiN layer having a thickness of 300 nm was formed as a protective layer on the organic EL element, exclusive of the terminal of the first electrode and the terminal of the second electrode, by a sputtering method.

(Sealing Step)

Subsequently, the organic EL element-formed substrate having the protective layer was fed into a room (sealing step section E in Fig. 4) set at a vacuum degree of 100 Pa or less, and a sealing film was continuously bonded onto the protective layer, exclusive of the terminal of the first electrode and the terminal of the second electrode, with an adhesive layer interposed between the protective layer and the sealing film, followed by heating the resulting laminate to thermally cure the adhesive layer.

Continuous bonding of the sealing film was performed while a separator was peeled off from a preliminarily prepared belt-shaped laminate including the sealing film using a bonding apparatus as illustrated in Fig. 7.

(Winding Step)

Subsequently, the organic EL element-formed substrate, to which the sealing film was bonded, was fed into a room (winding step section F in Fig. 4) set at a vacuum degree of 100 Pa or less, and wound in the form of a roll.

The organic EL panel according to the example was thus prepared using a roll-to-roll method. Fig. 8 is a sectional view of the organic EL panel prepared in the example.

[Comparative Example 1]

An organic EL element-formed substrate having a protective layer was prepared by carrying out preparation of a laminate including a flexible substrate and a sealing film, a drawing step, a heating step, an element forming step, and a protective layer forming step in the same manner as in the example described above.

(Sealing Step)

The organic EL element-formed substrate having a protective layer was fed into a room set at a vacuum degree of 100 Pa or less, and wound in the form of a roll on a temporary basis. Thereafter, a nitrogen gas was introduced into the room, so that the inside of the room was turned back to atmospheric pressure. Thereafter, in a nitrogen atmosphere, the roll-shaped organic EL element-formed substrate was transferred to a sealing step section provided independently of the above-mentioned room. The sealing step section of Comparative Example 1 includes a chamber kept under atmospheric pressure in a nitrogen atmosphere and in a dry state with a dew-point temperature of -60°C. In the chamber under atmospheric pressure, the roll-shaped organic EL element-formed substrate was continuously unwound, and a sealing film was continuously bonded onto the protective layer, exclusive of the terminal of the first electrode and the terminal of the second electrode, with an adhesive layer interposed between the protective layer and the sealing film, followed by heating the resulting laminate to thermally cure the adhesive layer.

The organic EL element-formed substrate, to which the sealing film was bonded, was wound in the form of a roll to prepare an organic EL panel according to Comparative Example 1.

[Comparative Example 2]

An organic EL panel according to Comparative Example 2 was prepared in the same manner as in Comparative Example 1 except that "a roll-shaped organic EL element-formed substrate was transferred to a sealing step section under an air atmosphere" instead of "transferring a roll-shaped organic EL element-formed substrate to a sealing step section in a nitrogen atmosphere" in the sealing step in Comparative Example 1.

[Comparative Example 3]

An organic EL panel according to Comparative Example 3 was prepared in the same manner as in Comparative Example 1 except that "a roll-shaped organic EL element-formed substrate was transferred to a sealing step section under an air atmosphere" instead of "transferring a roll-shaped organic EL element-formed substrate to a sealing step section in a nitrogen atmosphere", and "a chamber kept under an air atmosphere" was used instead of using "the chamber kept under atmospheric pressure in a nitrogen atmosphere and in a dry state with a dew-point temperature of-60°C" in the sealing step in Comparative Example 1.

[Light Emitting Test]

Each of the belt-shaped organic EL panel assemblies obtained from the example and Comparative Examples 1 to 3 described above was cut at a boundary between adjacent organic EL panels under an air atmosphere to obtain a plurality of organic EL panel pieces (length: 100 mm and width: 30 mm). For the obtained organic EL panel pieces of the example and comparative examples, an initial yield and a life were measured as described below. The results are shown in Table 1.

<Initial Yield (Dark Spot)>

20 pieces were randomly selected from a plurality of organic EL panel pieces of the example, and the 20 organic EL panel pieces were each made to emit light. An initial light emitting state of each piece was observed, and dark spots (circular non-light emitting areas) generated in a light emitting region of the panel were counted. An organic EL panel piece having 5 or more dark spots was rated as a defective item, while an organic EL panel piece having 4 or less dark spots was rated as a good item, and an initial yield based on dark spots was calculated. An initial yield based on dark spots was similarly calculated for the organic EL panel pieces of Comparative Examples 1 to 3.

<Initial Yield (Scratch)>

20 pieces were randomly selected from a plurality of organic EL panel pieces of the example, and the 20 organic EL panel pieces were each made to emit light. An initial light emitting state of each piece was observed, and scratches (linear non-light emitting areas) generated in a light emitting region of the panel were counted. An organic EL panel piece having 1 or more scratches was rated as a defective item, while an organic EL panel piece having no scratch was rated as a good item, and an initial yield based on scratches was calculated. An initial yield based on scratches was similarly calculated for the organic EL panel pieces of Comparative Examples 1 to 3.

<Initial Yield (Bubble)>

20 pieces were randomly selected from a plurality of organic EL panel pieces of the example, and the 20 organic EL panel pieces were each observed in a non-light-limiting state with an optical microscope. An organic EL panel piece having 3 or more bubbles in an adhesive layer (adhesive layer between a protective layer and a sealing film) was rated as a defective item, while an organic EL panel piece having 2 or less bubbles in the adhesive layer was rated as a good item, and an initial yield based on bubbles was calculated. An initial yield based on bubbles was similarly calculated for the organic EL panel pieces of Comparative Examples 1 to 3.

An initial yield is calculated from the equation: initial yield (%) = (number of good items/20) × 100.

<Life>

10 pieces were randomly selected from a plurality of organic EL panel pieces of the example, and stored in a non-light emitting state in a thermo-hygrostat set at 60°C/90% RH. After storage was started, the organic EL panel pieces were taken out from the thermo-hygrostat at each predetermined time, and made to emit light, and an area of a light emitting region was measured. A storage time when the area of the light emitting region of the panel piece measured after storage became a half of the area of the light emitting region of the panel piece before storage in the thermo-hygrostat was defined as a life. The results of the life in Table 1 are each an average value for 10 pieces. A life was similarly calculated for the organic EL panel pieces of Comparative Examples 1 to 3.

[Table 1]

| | Initial Yield (%) | | | Life (hr) |
|---|---|---|---|---|
| | Dark Spots | Scratches | Bubbles | |
| Example | 90 | 95 | 100 | 900 |
| Comparative Example 1 | 75 | 60 | 70 | 600 |
| Comparative Example 2 | 60 | 50 | 70 | 350 |
| Comparative Example 3 | 20 | 25 | 75 | 100 |

It is apparent that the organic EL panel obtained by the production method of the example has a high initial yield and a long life as compared to Comparative Examples 1 to 3 as shown in Table 1.

For the production method of Comparative Example 1, it is thought that the initial yield was reduced (dark spots, scratches and bubbles were increased) and the life was shortened due to the following factors: (a) a slight amount of oxygen and moisture contained in a nitrogen atmosphere infiltrates through very small pinholes or cracks of the protective layer, which are generated during and after formation of the protective layer, so that organic EL elements are degraded; and (b) the organic EL element-formed substrate is wound in the form of a roll immediately after formation of the protective layer, and consequently the protective layer is damaged.

For the production method of Comparative Example 2, it is thought that since the organic EL element-formed substrate having a protective layer was fed to the sealing step section under an air atmosphere, oxygen and moisture is more easily infiltrated into the organic EL element, resulting in a lower initial yield and a shorter life as compared to Comparative Example 1.

For the production method of Comparative Example 3, it is thought that the organic EL element-formed substrate having a protective layer was fed under an air atmosphere, and the sealing step was also carried out under an air atmosphere, resulting in a lower initial yield and a shorter life as compared to Comparative Example 2. The content of moisture is very high under an air atmosphere where the dew point is not controlled.

From the above, an organic EL panel having a high yield in the product initial stage and having excellent durability and high reliability can be produced by successively carrying out the element forming step, the protective layer forming step, and the sealing step by a roll-to-roll method without winding the flexible substrate in the form of a roll as in the example.

INDUSTRIAL APPLICABILITY

An organic EL panel of the present invention can be used for illuminating devices, image displays, or the like.

1 Organic EL panel
2 Flexible substrate
3 Organic EL element
31 First electrode
32 Second electrode
33 Organic layer
4 Protective layer
5 Sealing film
51 Adhesive layer
52 Separator
7 Vacuum chamber
8 Laminate

**Claims**

1. A method for producing an organic electroluminescence panel using a roll-to-roll method, the method comprising:

   an element forming step of forming an organic electroluminescence element on a flexible substrate;
   a protective layer forming step of forming a protective layer on the organic electroluminescence element;

and a sealing step of bonding a sealing film onto the protective layer,
wherein the element forming step, the protective layer forming step, and the sealing step are carried out successively in a vacuum chamber without winding the substrate in the form of a roll.

2. The method for producing an organic electroluminescence panel using a roll-to-roll method according to claim 1, wherein the method further comprises a heating step of heating the flexible substrate in the vacuum chamber before the element forming step.

Fig. 1

Fig. 2

```
┌─────────────────────────────────────────┐
│            Feeding of Substrate           │
└─────────────────────────────────────────┘
                     │
                     ▼
┌─────────────────────────────────────────┐
│      Washing and Drying of Substrate      │
└─────────────────────────────────────────┘
                     │              ,--Vacuum Chamber
                     ▼
   ┌ · · · · · · · · · · · · · · · · · · · · · · · · · ┐
   ·  ┌─────────────────────────────────────┐          ·
   ·  │            Heating Step              │          ·
   ·  └─────────────────────────────────────┘          ·
   ·                   │                                ·
   ·                   ▼                                ·
   ·  ┌─────────────────────────────────────┐          ·
   ·  │     Organic EL Element Forming Step  │          ·
   ·  └─────────────────────────────────────┘          ·
   ·                   │                                ·
   ·                   ▼                                ·
   ·  ┌─────────────────────────────────────┐          ·
   ·  │     Protective Layer Forming Step    │  Vacuum  ·
   ·  └─────────────────────────────────────┘          ·
   ·                   │                                ·
   ·                   ▼                                ·
   ·  ┌─────────────────────────────────────┐          ·
   ·  │             Sealing Step             │          ·
   ·  └─────────────────────────────────────┘          ·
   ·                   │                                ·
   ·                   ▼                                ·
   ·  ┌─────────────────────────────────────┐          ·
   ·  │      Winding of Organic EL Panel     │          ·
   ·  └─────────────────────────────────────┘          ·
   └ · · · · · · · · · · · · · · · · · · · · · · · · · ┘
```

# Fig.3

Fig. 4

5

VI                    VI

8

Fig. 5

5

51

52

8

Fig. 6

Fig. 7

Sealing Film
Adhesive Layer
Mg/Al Layer(Second Electrode)
Al Layer (Second Electrode)
Al Layer (First Electrode)
Stainless Steel Substrate
LiF, Alq3, NPB, HAT-CN (Organic Layer)

Fig. 8

## INTERNATIONAL SEARCH REPORT

| International application No. |
|---|
| PCT/JP2013/076831 |

| A. CLASSIFICATION OF SUBJECT MATTER |
|---|
| *H05B33/10*(2006.01)i, *H01L51/50*(2006.01)i, *H05B33/02*(2006.01)i, *H05B33/04* (2006.01)i |

According to International Patent Classification (IPC) or to both national classification and IPC

| B. FIELDS SEARCHED |
|---|
| Minimum documentation searched (classification system followed by classification symbols) |
| H05B33/10, H01L51/50, H05B33/02, H05B33/04 |

| Documentation searched other than minimum documentation to the extent that such documents are included in the fields searched |
|---|
| Jitsuyo Shinan Koho          1922–1996    Jitsuyo Shinan Toroku Koho    1996–2013 |
| Kokai Jitsuyo Shinan Koho    1971–2013    Toroku Jitsuyo Shinan Koho    1994–2013 |

Electronic data base consulted during the international search (name of data base and, where practicable, search terms used)

### C. DOCUMENTS CONSIDERED TO BE RELEVANT

| Category* | Citation of document, with indication, where appropriate, of the relevant passages | Relevant to claim No. |
|---|---|---|
| Y | JP 2009-256709 A  (Konica Minolta Holdings, Inc.), 05 November 2009 (05.11.2009), paragraphs [0029] to [0035] (Family: none) | 1-2 |
| Y | JP 2003-45652 A  (Matsushita Electric Industrial Co., Ltd.), 14 February 2003 (14.02.2003), paragraphs [0007] to [0008], [0014] (Family: none) | 1-2 |
| Y | WO 2005/094132 A1  (Pioneer Corp.), 06 October 2005 (06.10.2005), paragraphs [0003] to [0005]; fig. 1 (Family: none) | 2 |

☐ Further documents are listed in the continuation of Box C.     ☐ See patent family annex.

| * | Special categories of cited documents: | "T" | later document published after the international filing date or priority date and not in conflict with the application but cited to understand the principle or theory underlying the invention |
|---|---|---|---|
| "A" | document defining the general state of the art which is not considered to be of particular relevance | | |
| "E" | earlier application or patent but published on or after the international filing date | "X" | document of particular relevance; the claimed invention cannot be considered novel or cannot be considered to involve an inventive step when the document is taken alone |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search | Date of mailing of the international search report |
|---|---|
| 11 December, 2013 (11.12.13) | 24 December, 2013 (24.12.13) |

| Name and mailing address of the ISA/ | Authorized officer |
|---|---|
| Japanese Patent Office | |
| Facsimile No. | Telephone No. |

Form PCT/ISA/210 (second sheet) (July 2009)